# EUROPÄISCHE PATENTSCHRIFT

(11) **EP 3 436 834 B1**
(45) Veröffentlichungstag und Bekanntmachung des Hinweises auf die Patenterteilung: **30.04.2025**
(21) Anmeldenummer: 17714690.9
(22) Anmeldetag: 28.03.2017
(51) Int. Cl.: G01R 15/04, G05B 19/042

(54) **ANORDNUNG MIT MINDESTENS ZWEI REDUNDANTEN ANALOGEINGABEEINHEITEN FÜR EINEN MESSSTROM**
ARRANGEMENT WITH AT LEAST TWO REDUNDANT ANALOG INPUT UNITS FOR A MEASURING CURRENT
AGENCEMENT AVEC AU MOINS DEUX UNITÉS D'ENTRÉE ANALOGIQUE REDONDANTES POUR UN COURANT DE MESURE

(30) Priorität: 30.03.2016 EP 16162780
(43) Veröffentlichungstag der Anmeldung: 06.02.2019
(73) Patentinhaber: Siemens Aktiengesellschaft, 80333 München (DE)
(72) Erfinder: MAIER, Willi, 77728 Oppenau (DE); ROTTMANN, Norbert, 76829 Landau (DE)
(74) Vertreter: Siemens Patent Attorneys
(86) Internationale Anmeldenummer: PCT/EP2017/057284
(87) Internationale Veröffentlichungsnummer: WO 2017/167732

(56) Entgegenhaltungen:
- WO-A1-2015/128336
- WO-A2-03/039904

## Beschreibung

Die Erfindung betrifft eine Anordnung mit mindestens zwei redundanten Analogeingabeeinheiten für einen Messstrom, welche
- parallel geschaltete Analogeingänge für den Messstrom aufweisen und jeweils
- einen Strommesswiderstand,
- eine Spannungsmesseinrichtung mit einem hochohmigen Spannungsmesseingang zur Umsetzung einer an dem Spannungsmesseingang anliegenden Spannung in einen digitalen Messwert,
- einen Digitalausgang zur Ausgabe des digitalen Messwerts sowie
- eine steuerbare Umschalteinrichtung zur Umschaltung des Analogeingangs zwischen einem hochohmigen Zustand und einem niederohmigen Zustand enthalten, wobei in dem niederohmigen Zustand der Strommesswiderstand zugleich an dem Analogeingang und dem hochohmigen Spannungsmesseingang liegt, wobei
- die Analogeingabeeinheiten über eine Kommunikationsverbindung miteinander verbunden und dazu ausgebildet sind, eine der Analogeingabeeinheiten festzulegen, die zur Messung und Umsetzung des Messstroms in einen digitalen Messwert ihren Analogeingang in den niederohmigen Zustand schaltet, während in jeder übrigen Analogeingabeeinheit der Analogeingang in den hochohmigen Zustand geschaltet ist.

Eine derartige aus der WO 2015/128336 A1 bekannte Anordnung weist zwei redundante Eingabeeinheiten auf, die jeweils wahlweise als Analogeingabeeinheit für einem Messstrom oder als Binäreingabeeinheit für eine Spannung betrieben werden. Zur Umschaltung zwischen diesen beiden Betriebszuständen enthält jeder Eingabeeinheit eine Umschalteinrichtung, bei der eine Parallelschaltung aus einem hochohmigen Widerstand und einem steuerbaren Schalter in Reihe mit dem niederohmigen Strommesswiderstand an dem Eingang der Eingabeeinheit liegt. Der Spannungsmesseingang der Spannungsmesseinrichtung liegt an dem Strommesswiderstand.

Im redundanten Betrieb als Binäreingabeeinheiten ist bei beiden Eingabeeinheiten jeweils der steuerbare Schalter geöffnet, so dass der hochohmige Widerstand und der niederohmige Strommesswiderstand einen Spannungsteiler bilden und die Spannungsmesseinrichtung einen High- oder Low-Pegel der an dem Eingang der jeweiligen Binäreingabeeinheit anliegenden Spannung misst.

Im redundanten Betrieb als Analogeingabeeinheiten für einen Messstrom ist zumindest bei einer der beiden Eingabeeinheiten der steuerbare Schalter geschlossen, so dass der hochohmige Widerstand unwirksam ist. Sind in beiden Eingabeeinheiten die steuerbaren Schalter geschlossen, so teilt sich der Messstrom je zur Hälfte auf die beiden niederohmigen Strommesswiderstände auf, so dass die nachgeordneten Spannungsmesseinrichtungen jeweils den halben Messstrom als Spannungsabfall über ihrem niederohmigen Strommesswiderstand messen. Die jeweilige Eingabeeinheit nimmt dann eine rechnerische Korrektur um den Faktor 2 vor, bevor sie den digitalen Messwert des Messstroms ausgibt. Ist der steuerbare Schalter in nur einer der beiden Eingabeeinheiten geschlossen, so teilt sich der Messstrom in einem anderen Verhältnis auf den Strommesswiderstand in der Eingabeeinheit mit dem geschlossenen Schalter und auf die Reihenschaltung der Widerstände in der anderen Eingabeeinheit auf, so dass die nachgeordneten Spannungsmesseinrichtungen die entsprechenden Anteile des Messstroms als Spannungsabfälle über ihren niederohmigen Strommesswiderständen messen. Auch hier nimmt z. B. die Eingabeeinheit mit dem geschlossenen Schalter eine rechnerische Korrektur um das Verhältnis der Aufteilung des Messstroms auf die redundanten Eingabeeinheiten vor, bevor sie den digitalen Messwert ausgibt. Eine gewünschte Aufteilung des Messstroms im Verhältnis von 97% zu 3% erhält man mit einem Widerstandsverhältnis von 1 zu 31,33 zwischen dem Strommesswiderstand und dem hochohmigen Widerstand. Jedoch wird die Präzision der Aufteilung des Messstroms über das angegebene Widerstandsverhältnis und damit die Präzision der rechnerischen Messwertkorrektur durch die unvermeidbaren und unbekannten Leitungswiderstände zwischen den beiden Analogeingabeeinheiten eingeschränkt.

Zwischen den beiden redundanten Eingabeeinheiten der bekannten Anordnung besteht eine Kommunikationsverbindung. Über diese erkennen sie, ob jeweils ein Redundanzpartner vorhanden ist; sie legen fest, welche von ihnen als Master die Messaufgabe ausführt, und teilen bei einem bei Ausfall des Masters die entsprechende Funktion der jeweils anderen Eingabeeinheit zu.

WO 03/039904 A2 offenbart einen Halbleiterschalter zum Schalten einer, z. B., induktiven Last. Bei dem Halbleiterschalter handelt es sich um einen Sense-FET, der über einen Messwiderstand einen zu dem Laststrom proportionalen Teilstrom erfasst. Zur Erhöhung der Betriebssicherheit wird der Teilstrom zusätzlich (redundant) gemessen, indem der von ihm an dem Messwiderstand hervorgerufene Spannungsabfall mittels eines Signalverstärkers erfasst und in einen digitalen Messwert umgesetzt wird. Dieser kann in Bezug auf einen vorgegebenen oberen und/oder unteren Schwellwert ausgewertet werden, indem bei Über- oder Unterschreitung des Schwellwerts ein logisches High- oder logisches Low-Signal erzeugt wird. Zusätzlich zu der redundanten Strommessung können zur weiteren Erhöhung der Betriebssicherheit auch zwei oder mehr Sense-FETs verwendet werden, um dieselbe Last zu schalten. Die Sense-FETs mit der redundanten Strommessung können auch in unterschiedlichen Stromkreisen (Treiberstromkreis und Freilaufstromkreis) der induktiven Last angeordnet sein. Eine Umschaltung eines Analogeingangs zwischen einem hochohmigen Zustand und einem niederohmigen Zustand ist nicht vorgesehen. Ausgehend von der aus der WO 2015/128336 A1 bekannten Anordnung liegt der Erfindung die Aufgabe zugrunde, eine redundante Analogeingabe für einen Messstrom zu ermöglichen, die ohne rechnerische Korrektur der ermittelten Messwerte auskommt.

Gemäß der Erfindung, die durch die Merkmale des Anspruchs 1 definiert ist, wird die Aufgabe dadurch gelöst, dass bei der Anordnung der eingangs angegebenen Art
- bei jeder Analogeingabeeinheit der hochohmige Spannungsmesseingang der Spannungsmesseinrichtung unmittelbar mit dem Analogeingang verbunden ist und
- jede der mindestens zwei Analogeingabeeinheiten dazu ausgebildet ist, sowohl im hochohmigen als auch im niederohmigen Zustand ihres Analogeingangs den von ihr aktuell erzeugten digitalen Messwert mit einem Schwellenwert zu vergleichen, eine Fehlermeldung auszugeben, wenn der digitalen Messwert den Schwellenwert unterschreitet, und, falls ihr Analogeingang in dem niederohmigen Zustand ist, eine andere der Analogeingabeeinheiten zu veranlassen, ihren Analogeingang zur Messung und Umsetzung des Messstroms in einen digitalen Messwert in den niederohmigen Zustand zu schalten.

Da bei jeder Analogeingabeeinheit der Spannungsmesseingang der Spannungsmesseinrichtung unmittelbar an dem Analogeingang liegt, messen alle redundanten Analogeingabeeinheiten praktisch dieselbe Spannung, nämlich den Spannungsabfall an dem Strommesswiderstand der einen Analogeingabeeinheit, deren Analogeingang in den niederohmigen Zustand geschaltet ist. Es erfolgt im Unterschied zu der aus der eingangs genannten WO 2015/128336 A1 bekannten Anordnung keine Spannungsteilung, so dass das Widerstandsverhältnis zwischen dem hochohmigen Widerstand und dem Strommesswiderstand keine Rolle spielt und daher nicht nur höher gewählt werden kann, sondern in der Praxis mit einem Faktor größer 1000 auch wesentlich höher gewählt wird, und somit keine oder lediglich eine im Rahmen der Messgenauigkeit vernachlässigbare Teilung des Messstroms auf die redundanten Analogeingabeeinheit stattfindet.

Da, wie oben erläutert, alle redundanten Analogeingabeeinheiten zumindest annähernd denselben Spannungsabfall erfassen, können sie sich selbst überwachen, indem jede Analogeingabeeinheit unabhängig davon, ob ihr Analogeingang jeweils in den niederohmigen oder in den hochohmigen Zustand geschaltet ist, die an ihrem Analogeingang anliegende Spannung in einen digitalen Messwert umsetzt und diesen mit einem Schwellenwert vergleicht. So sinkt im Falle einer Spannungs- oder Stromunterbrechung am Analogeingang einer Analogeingabeeinheit die von dem Spannungsmesseingang der Spannungsmesseinrichtung erfasste Spannung unter den Schwellenwert bis auf den Wert Null. Ursache einer solchen Unterbrechung kann ein Fehler sein, z. B. ein Leitungsbruch, aber auch dass die strommessende Analogeingabeeinheit beispielsweise zur Kalibrierung oder infolge eines Baugruppentausches aus einem Rack entfernt wird. Dies wird nun automatisch detektiert und führt dazu, dass die betroffene Analogeingabeeinheit anstelle eines Messwerts eine Fehlermeldung ausgibt. Dabei kann es sich um einen Wert handeln, der außerhalb des gültigen Messbereichs liegt, oder eine Information, z. B. ein Bit, die den Messwert als fehlerhaft kennzeichnet handeln. Wenn es sich bei der betroffenen Analogeingabeeinheit um die jeweils strommessende Analogeingabeeinheit handelt, deren Analogeingang in den niederohmigen Zustand geschaltet ist, gibt diese ein Detektionssignal auf die Kommunikationsverbindung, um eine oder die andere redundante Analogeingabeeinheit dazu zu veranlassen, ihren Analogeingang in den niederohmigen Zustand zu schalten und die Strommessfunktion zu übernehmen. Die bisher strommessende Analogeingabeeinheit schaltet außerdem vorzugsweise ihren Analogeingang in den hochohmigen Zustand.

Im Idealfall messen alle redundanten Analogeingabeeinheiten denselben Spannungsabfall, so dass grundsätzlich jede Analogeingabeeinheit die von ihr erfasste Spannung in einen digitalen Messwert für den Messstrom umzusetzen und über ihren Digitalausgang ausgeben kann. Da jedoch in der Praxis nur die Strommesswiderstände als Präzisionswiderstände ausgebildet sind und zwischen den Analogeingängen der verschiedenen Analogeingabeeinheiten ggf. nicht vernachlässigbare Leitungswiderstände vorhanden sein können, kann bei sehr hohen Anforderungen an die Messauflösung in Verbindung mit ebenfalls sehr hoher Messgenauigkeit nicht mehr ohne Weiteres davon ausgegangen werden, dass die von der oder den Analogeingabeeinheiten mit den hochohmig geschalteten Analogeingängen erzeugten Messwerte den genannten Anforderungen genügen. Für diesen Fall sind die Analogeingabeeinheiten dazu ausgebildet, im hochohmigen Zustand ihres Analogeingangs anstelle des selbst erzeugten Messwerts den von der strommessenden Analogeingabeeinheit mit dem niederohmigen Analogeingang erzeugten digitalen Messwert über die Kommunikationsverbindung entgegenzunehmen und auszugeben.

Der Umstand, dass sich die Analogeingabeeinheiten selbst überwachen, ist insbesondere dann von Vorteil, wenn aus Gründen der Redundanz bei der Übertragung des Messstroms die redundanten Analogeingabeeinheiten über separate Leitungen an einem den Messstrom liefernden Messstromgeber (z. B. 4-20 mA Messumformer) angeschlossen sind. Dann wird jede der separaten Leitungen auf Drahtbruch überwacht.

Wie oben bereits erläutert, besteht ein wesentliches Merkmal der Erfindung darin, dass bei jeder Analogeingabeeinheit der Spannungsmesseingang der Spannungsmesseinrichtung unmittelbar an dem Analogeingang liegt. Dies kann dadurch realisiert werden, dass die Umschalteinrichtung eine Reihenschaltung aus dem Strommesswiderstand und einem steuerbaren Schalter umfasst, die parallel mit einem hochohmigen Widerstand an dem Analogeingang und dem Spannungsmesseingang liegt. Alternativ umfasst die Umschalteinrichtung eine Parallelschaltung aus einem hochohmigen Widerstand und einem steuerbaren Schalter, die in Reihe mit dem Strommesswiderstand an dem Analogeingang und dem Spannungsmesseingang liegt.

Zur weiteren Erläuterung der Erfindung wird im Folgenden auf die Figuren der Zeichnung Bezug genommen; im Einzelnen zeigen jeweils in schematischer Darstellung:
- Fig. 1: ein erstes Ausführungsbeispiel der erfindungsgemäßen Anordnung und
- Fig. 2: ein zweites Ausführungsbeispiel der erfindungsgemäßen Anordnung.

Gleiche Bezugszeichen haben in den verschiedenen Figuren die gleiche Bedeutung.

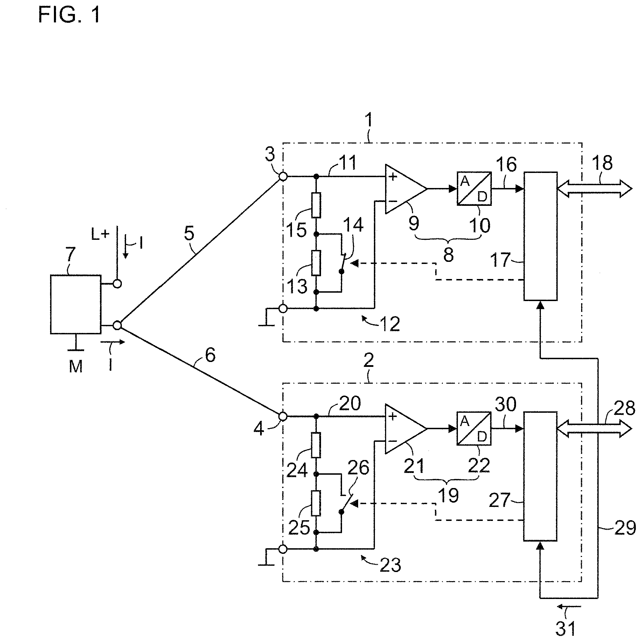

Fig. 1 zeigt zwei redundant arbeitende Analogeingabeeinheiten 1, 2, die mit ihren Analogeingängen 3, 4 über separate Leitungen 5, 6 parallel an einem Messstromgeber 7 angeschlossen sind. Bei dem Messstromgeber 7 handelt es sich beispielsweise um einen Messumformer, der ein zu einer erfassten Messgröße proportionalen Messstrom I zwischen 4 und 20 mA erzeugt.

Die Analogeingabeeinheit 1 enthält eine Spannungsmesseinrichtung 8 bestehend aus einem Differenzverstärker 9 und einem nachgeordneten Analog-/Digital-Umsetzer 10, die mit ihrem Spannungsmesseingang 11 unmittelbar an dem Analogeingang 3 liegt; d. h. der Analogeingang 3 ist der Spannungsmesseingang 11. Der Analogeingang 3 ist mittels einer steuerbaren Umschalteinrichtung 12 zwischen einem hochohmigen Zustand und einem niederohmigen Zustand umschaltbar. Die Umschalteinrichtung 12 besteht aus einer Parallelschaltung aus einem hochohmigen Widerstand 13 und einem steuerbaren Schalter 14, die in Reihe mit einem niederohmigen Strommesswiderstand 15 an dem Analogeingang 3 bzw. dem Spannungsmesseingang 11 liegt. Der Strommesswiderstand 15 ist als Präzisionswiderstand ausgebildet und hat einen Widerstandswert von beispielsweise 250 Ω. Der hochohmige Widerstand 13 hat einen Widerstandswert von beispielsweise 1 MΩ. Bei geschlossenem Schalter 14, also im niederohmigen Zustand des Analogeingangs 3, erfasst die Spannungsmesseinrichtung 8 den von dem Messstrom I über dem Strommesswiderstand 15 erzeugten Spannungsabfall und setzt diesen in einen digitalen Messwert 16 für die erfasste Messgröße um. Dieser wird von einer Steuereinrichtung (CPU) 17 über einen Digitalausgang 18 als Schnittstelle zu einer hier nicht gezeigten übergeordneten Steuerung ausgegeben. Die Steuereinrichtung 17 steuert auch die Umschalteinrichtung 12. Die zweite Analogeingabeeinheit 2 ist baugleich mit der Analogeingabeeinheit 1 und enthält eine Spannungsmesseinrichtung 19, deren hochohmiger Spannungsmesseingang 20 mit dem Analogeingang 4 zusammenfällt und die aus einem Differenzverstärker 21 und einem nachgeordneten Analog-/Digital-Umsetzer 22 besteht. An dem Analogeingang 4 bzw. dem Spannungsmesseingang 20 liegt eine Umschalteinrichtung 23 mit einem niederohmigen Strommesswiderstand 24 in Reihe mit einer Parallelschaltung aus einem hochohmigen Widerstand 25 und einem steuerbaren Schalter 26. Dieser wird von einer Steuereinrichtung 27 gesteuert, die auch einen digitalen Messwert über einen Digitalausgang 28 ausgibt.

Die Steuereinrichtungen 17, 27 der beiden redundanten Analogeingabeeinheiten 1, 2 kommunizieren über eine Kommunikationsverbindung 29, z. B. RS-485, miteinander und sorgen dafür, dass immer nur bei einer der beiden Analogeingabeeinheiten 1, 2, hier z. B. der Analogeingabeeinheit 1, der Analogeingang 3 in den niederohmigen Zustand geschaltet ist. Bei der anderen und ggf. jeder weiteren redundanten Analogeingabeeinheit 2 ist der Schalter 26 geöffnet und dementsprechend der Analogeingang 4 in den hochohmigen Zustand geschaltet. Während die Analogeingabeeinheit 1 den Messstrom I misst und in den digitalen Messwert 16 umsetzt und ausgibt, überwacht die Analogeingabeeinheit 2 lediglich die Spannung an ihrem Analogeingang 4, wozu die Spannung ebenfalls in einen digitalen Messwert 30 umgesetzt wird. Aufgrund seines sehr hohen Widerstandswerts beeinträchtigt der Widerstand 25 die Strommessung in der Analogeingabeeinheit 1 nicht oder nur in einem vernachlässigbar geringen Maße. Die von der Spannungsmesseinrichtung 19 der Analogeingabeeinheit 2 gemessene Spannung entspricht dem Spannungsabfall über dem Strommesswiderstand 15 in der Analogeingabeeinheit 1 zuzüglich dem von dem Messstrom I hervorgerufenen Spannungsabfall über der Leitung 5. Da der zuletzt genannte Spannungsabfall in Bezug auf die Messgenauigkeit nicht vernachlässigbar ist, übernimmt die Analogeingabeeinheit 2 den von der strommessenden Analogeingabeeinheit 1 erzeugten und über die Kommunikationsverbindung 29 mitgeteilten digitalen Messwert 16 und gibt diesen anstelle des eigenen Messwerts 30 redundant über ihren Digitalausgang 28 aus.

In beiden Analogeingabeeinheiten 1, 2 vergleicht die jeweilige Steuereinrichtung 17, 27 den erzeugten digitalen Messwert 16, 30 mit einem vorgegebenen Schwellenwert. Bei einer Unterbrechung der Leitung 6 fällt die Spannung an dem Analogeingang 4 bzw. dem Spannungsmesseingang 20 auf den Wert Null, so dass der digitale Messwert 30 den vorgegebenen Schwellenwert unterschreitet. In diesem Fall wird anstelle des von der strommessenden Analogeingabeeinheit 1 über die Kommunikationsverbindung 29 empfangenen Messwerts 16 eine Fehlermeldung ausgegeben oder der ausgegebene Messwert 16 wird als fehlerhaft gekennzeichnet.

Wird umgekehrt bei der strommessenden Analogeingabeeinheit 1 ein Drahtbruch erkannt, dann wird ebenfalls über den Digitalausgang 18 eine Fehlermeldung ausgegeben. Durch Öffnen des Schalters 14 wird der Analogeingang 3 in den hochohmigen Zustand geschaltet und die redundante Analogeingabeeinheit 2 durch Ausgabe eines Detektions-/Befehlssignals 31 über die Kommunikationsverbindung 29 dazu veranlasst, ihren Analogeingang 4 niederohmig zu schalten, die Strommessfunktion zu übernehmen und die erzeugten Messwerte 30 über die Kommunikationsverbindung 29 an die Analogeingabeeinheit 1 zu übertragen.

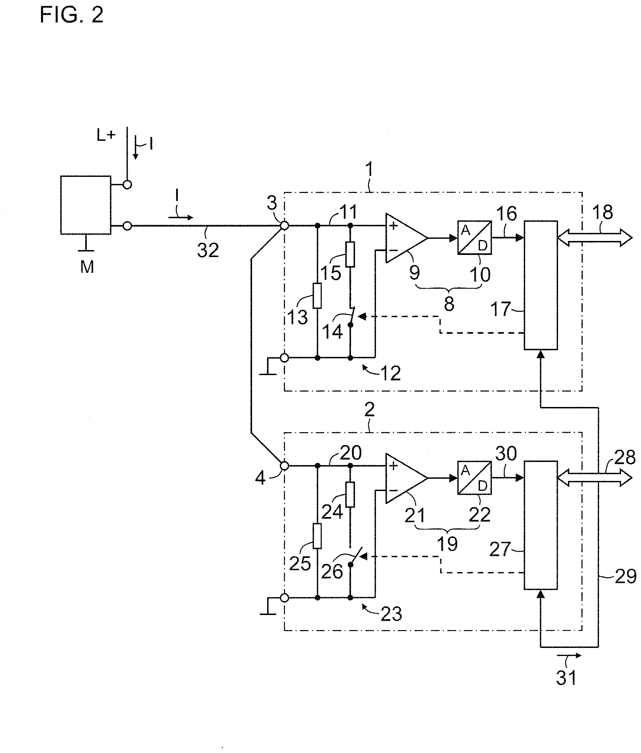

Das in Fig. 2 gezeigte Ausführungsbeispiel unterscheidet sich von dem nach Fig. 1 dadurch, dass zum einen die beiden Analogeingabeeinheiten 1, 2 an ihren Analogeingängen 3, 4 unmittelbar parallel geschaltet und über eine Leitung 32 an dem Messstromgeber 7 angeschlossen sind, und zum anderen die Umschalteinrichtungen 12, 23 jeweils eine Reihenschaltung aus dem Strommesswiderstand 15, 24 und dem steuerbaren Schalter 14, 26 umfasst, die zusammen mit dem hochohmigen Widerstand 13, 25 jeweils parallel an dem Analogeingang 3, 4 und dem Spannungsmesseingang 11, 20 liegt. Beide Abwandlungen sind unabhängig voneinander und können jeweils auch alleine realisiert werden.

## Patentansprüche

1. Anordnung mit mindestens zwei redundanten Analogeingabeeinheiten (1, 2) für einen Messstrom (I), welche
- parallel geschaltete Analogeingänge (3, 4) für den Messstrom (I) aufweisen und jeweils
- einen Strommesswiderstand (15, 24),
- eine Spannungsmesseinrichtung (8, 19) mit einem hochohmigen Spannungsmesseingang (11, 20) zur Umsetzung einer an dem Spannungsmesseingang (11, 20) anliegenden Spannung in einen digitalen Messwert (16),
- einen Digitalausgang (18, 28) zur Ausgabe des digitalen Messwerts (16) sowie
- eine steuerbare Umschalteinrichtung (12, 23) zur Umschaltung des Analogeingangs (3, 4) zwischen einem hochohmigen Zustand und einem niederohmigen Zustand enthalten, welche Umschalteinrichtung (12, 23) aus einer Parallelschaltung aus einem hochohmigen Widerstand (13, 25) und einem steuerbaren Schalter (14, 26) besteht, wobei in dem niederohmigen Zustand der Strommesswiderstand (15, 24) zugleich an dem Analogeingang (3, 4) und dem hochohmigen Spannungsmesseingang (11, 20) liegt, wobei
- die Analogeingabeeinheiten (1, 2) über eine Kommunikationsverbindung (29) miteinander verbunden und dazu ausgebildet sind, eine der Analogeingabeeinheiten (z. B. 1) festzulegen, die zur Messung und Umsetzung des Messstroms (I) in einen digitalen Messwert (16) ihren Analogeingang (3) in den niederohmigen Zustand schaltet, während in jeder übrigen Analogeingabeeinheit (2) der Analogeingang (4) in den hochohmigen Zustand geschaltet ist,
wobei
- bei jeder Analogeingabeeinheit (1, 2) der hochohmige Spannungsmesseingang (11, 20) der Spannungsmesseinrichtung (8, 19) bei einem geöffneten Schalter (14, 26) der besagten Schalter (14, 26) unmittelbar mit dem Analogeingang (3, 4) verbunden ist und
- jede der mindestens zwei Analogeingabeeinheiten (1, 2) dazu ausgebildet ist, sowohl im hochohmigen als auch im niederohmigen Zustand ihres Analogeingangs (3, 4) den von ihr aktuell erzeugten digitalen Messwert (16, 30) mit einem Schwellenwert zu vergleichen, eine Fehlermeldung auszugeben, wenn der digitale Messwert (16, 30) den Schwellenwert unterschreitet, und, falls ihr Analogeingang (z. B. 3) in dem niederohmigen Zustand ist, eine andere der Analogeingabeeinheiten (z. B. 2) zu veranlassen, ihren Analogeingang (4) zur Messung und Umsetzung des Messstroms (I) in einen digitalen Messwert in den niederohmigen Zustand zu schalten,
**dadurch gekennzeichnet, dass**
jede Analogeingabeeinheit (z. B. 2) weiterhin dazu ausgebildet ist, im hochohmigen Zustand ihres Analogeingangs (4) anstelle des selbst erzeugten digitalen Messwerts (30) den von der Analogeingabeeinheit (1) mit dem niederohmigen Analogeingang (3) erzeugten und von dieser über die Kommunikationsverbindung (29) erhaltenen digitalen Messwert (16) auszugeben.

2. Anordnung nach Anspruch 1, **dadurch gekennzeichnet, dass** jede Analogeingabeeinheit (z. B. 1) ferner dazu ausgebildet ist, im niederohmigen Zustand ihres Analogeingangs (3) diesen in den hochohmigen Zustand umzuschalten, wenn der digitale Messwert (16, 30) den Schwellenwert unterschreitet.

3. Anordnung nach Anspruch 1 oder 2, **dadurch gekennzeichnet, dass** die Umschalteinrichtung (12, 23) eine Reihenschaltung aus dem Strommesswiderstand (15, 24) und dem steuerbaren Schalter (14, 26) umfasst, wobei die Reihenschaltung parallel zu dem hochohmigen Widerstand (13, 25) an dem Analogeingang (3, 4) und dem Spannungsmesseingang (11, 20) liegt.

4. Anordnung nach einem der vorangehenden Ansprüche, **dadurch gekennzeichnet, dass** die redundanten Analogeingabeeinheiten (1, 2) über separate Leitungen (5, 6) an einem den Messstrom (I) liefernden Messstromgeber (7) angeschlossen sind.

5. Anordnung nach einem der Ansprüche 1 bis 3, **dadurch gekennzeichnet, dass** die redundanten Analogeingabeeinheiten (1, 2) an ihren Analogeingängen (3, 4) parallel geschaltet über eine Leitung (32) an einem den Messstrom (I) liefernden Messstromgeber (7) angeschlossen sind.

## Claims

1. Assembly with at least two redundant analogue input units (1, 2) for a measurement current (I), having
- parallel-connected analogue entry points (3, 4) for the measurement current (I), and containing in each case
- a current-measuring resistor (15, 24),
- a voltage-measuring device (8, 19) with a high-ohmic voltage-measuring entry point (11, 20), for converting a voltage that is applied to the voltage-measuring entry point (11, 20) into a digital measurement value (16),
- a digital output (18, 28) for outputting the digital measurement value (16), and
- a controllable switching device (12, 23) for switching the analogue entry point (3, 4) between a high-ohmic state and a low-ohmic state, which switching device (12, 23) consists of a parallel circuit comprising a high-ohmic resistor (13, 25) and a controllable switch (14, 26), wherein in the low-ohmic state the current-measuring resistor (15, 24) is situated at both the analogue entry point (3, 4) and the high-ohmic voltage-measuring entry point (11, 20), wherein
- the analogue input units (1, 2) are connected together via a communication connection (29) and are designed to select one of the analogue input units (for example 1), which switches its analogue entry point (3) into the low-ohmic state in order to measure and convert the measurement current (I) into a digital measurement value (16) while the analogue entry point (4) in each remaining analogue input unit (2) is switched into the high-ohmic state,
wherein
- in each analogue input unit (1, 2), the high-ohmic voltage-measuring entry point (11, 20) of the voltage-measuring device (8, 19) is directly connected to the analogue entry point (3, 4) in one switch (14, 26) of said switches (14, 26) is open and
- each of the at least two analogue input units (1, 2) is designed to compare, in both the high-ohmic and low-ohmic state of its analogue entry point (3, 4), its currently generated digital measurement value (16, 30) with a threshold value, to output an error message if the digital measurement value (16, 30) falls below the threshold value and, if its analogue entry point (for example 3) is in the low-ohmic state, to cause another of the analogue input units (for example 2) to switch its analogue entry point (4) into the low-ohmic state in order to measure and convert the measurement current (I) into a digital measurement value,
**characterised in that**
each analogue input unit (for example 2) is further designed, when in the high-ohmic state of its analogue entry point (4), instead of the measurement value (30) that was generated locally, to output the digital measurement value (16) that was generated by the analogue input unit (1) having the low-ohmic analogue entry point (3) and received therefrom via the communication connection (29).

2. Assembly according to claim 1, **characterised in that** each analogue input unit (for example 1) is further designed, when in the low-ohmic state of its analogue entry point (3), to switch this into the high-ohmic state if the digital measurement value (16, 30) falls below the threshold value.

3. Assembly according to claim 1 or 2, **characterised in that** the switching device (12, 23) comprises a series circuit consisting of the current-measuring resistor (15, 24) and a controllable switch (14, 26), wherein said series circuit is situated in parallel with a high-ohmic resistor (13, 25) at the analogue entry point (3, 4) and the voltage-measuring entry point (11, 20).

4. Assembly according to one of the preceding claims, **characterised in that** the redundant analogue input units (1, 2) are connected via separate lines (5, 6) to a measurement current sensor (7) supplying the measurement current (I).

5. Assembly according to one of claims 1 to 3, **characterised in that** the redundant analogue input units (1, 2) are wired in parallel at their analogue entry points (3, 4) and connected via a line (32) to a measurement current sensor (7) supplying the measurement current (I).

## Revendications

1. Montage comprenant au moins deux unités (1, 2) d'entrée analogique redondantes pour un courant (I) de mesure, lesquelles
- ont des entrées (3, 4) analogiques montées en parallèle pour le courant (I) de mesure et respectivement
- une résistance (15, 24) de mesure du courant,
- un dispositif (8, 19) de mesure de la tension ayant une entrée (11, 20) de mesure de la tension à grande valeur ohmique pour la transformation d'une tension appliquée à l'entrée (11, 20) de mesure de la tension en une valeur (16) de mesure numérique,
- une sortie (18, 28) numérique pour la sortie de la valeur (16) de mesure numérique ainsi que
- un dispositif (12, 23) de commutation pouvant être commandé pour la commutation de l'entrée (3, 4) analogique entre un état à grande valeur ohmique et un état à petite valeur ohmique, lequel dispositif (12, 23) de commutation est constitué d'un circuit parallèle composé d'une résistance (13, 25) à grande valeur ohmique et d'un interrupteur (14, 26) pouvant être commandé, dans lequel dans l'état à petite valeur ohmique la résistance (15, 24) de mesure du courant s'applique en même temps à l'entrée (3, 4) analogique et à l'entrée (11, 20) de mesure de la tension à grande valeur ohmique, dans lequel
- les unités (1, 2) d'entrée analogique communiquent entre elles par une liaison (29) de communication et sont conçues pour constater que l'une des unités (par exemple 1) d'entrée analogique, met, pour la mesure et la transformation du courant (I) de mesure en une valeur (16) de mesure numérique, son entrée (3) analogique dans l'état à petite valeur ohmique, tandis que dans chaque autre unité (2) analogique, l'entrée (4) analogique est dans l'état à grande valeur ohmique,
dans lequel
- dans chaque unité (1, 2) d'entrée analogique, l'entrée (11, 20) de mesure de la tension à grande valeur ohmique du dispositif (8, 19) de mesure de la tension est, pour un interrupteur (14, 26) ouvert dudit interrupteur (14, 26), reliée directement à l'entrée (3, 4) analogique et
- chacune des au moins deux unités (1, 2) d'entrée analogique est constituée pour comparer, tant dans l'état à grande valeur ohmique qu'également dans l'état à petite valeur ohmique de son entrée (3, 4) analogique, la valeur (16, 30) de mesure numérique, qu'elle est en cours de produire, à une valeur de seuil, pour émettre un message d'erreur, si la valeur (16, 30) de mesure numérique passe en-dessous de la valeur de seuil et, si son entrée (par exemple 3) analogique est dans l'état à petite valeur ohmique, faire qu'une autre des unités (par exemple 2) d'entrée analogique mette son entrée (4) analogique pour la mesure et la conversion du courant (I) de mesure en une valeur de mesure numérique dans l'état à petite valeur ohmique,
**caractérisé en ce que**
chaque unité (par exemple 2) d'entrée analogique est constituée en outre pour, dans l'état à grande valeur ohmique de son entrée (4) analogique, sortir au lieu de la valeur (30) de mesure numérique produite elle-même, la valeur (16) de mesure numérique produite par l'unité (1) d'entrée analogique ayant l'entrée (3) analogique à petite valeur ohmique, et obtenue par celle-ci en passant par la liaison (29) de communication.

2. Montage suivant la revendication 1, **caractérisé en ce que** chaque unité (par exemple 1) d'entrée analogique est constituée en outre pour, dans l'état à petite valeur ohmique de son entrée (3) analogique, mettre celle-ci dans l'état à grande valeur ohmique, si la valeur (16, 30) de mesure numérique passe en-dessous de la valeur de seuil.

3. Montage suivant la revendication 1 ou 2, **caractérisé en ce que** le dispositif (12, 23) de commutation comprend un circuit série composé de la résistance (15, 24) de mesure du courant et de l'interrupteur (14, 26) pouvant être commandé, dans lequel le circuit série est monté en parallèle à la résistance (13, 25) à grande valeur ohmique à l'entrée (3, 4) analogique et à l'entrée (11, 20) de mesure de la tension.

4. Montage suivant l'une des revendications précédentes, **caractérisé en ce que** les unités (1, 2) d'entrée analogique redondantes sont raccordées par des lignes (5, 6) distinctes à un transmetteur (7) du courant de mesure donnant le courant (I) de mesure.

5. Montage suivant l'une des revendications 1 à 3, **caractérisé en ce que** les unités (1, 2) d'entrée analogique redondantes, montées en parallèle à leurs entrées (3, 4) analogiques, sont raccordées par une ligne (32) à un transmetteur (7) de courant de mesure donnant le courant (I) de mesure.
